# EUROPEAN PATENT APPLICATION

(11) **EP 2 848 586 A1**
(43) Date of publication of application: **18.03.2015**
(21) Application number: 13199215.8
(22) Date of filing: 20.12.2013
(51) Int. Cl.: B81C 1/00

(54) **Wafer level encapsulation structure and fabrication method thereof**

(30) Priority: 13.09.2013 US 201361877332 P
(71) Applicant: Teknologian Tutkimuskeskus VTT, 02044 VTT (FI)
(72) Inventor: Dekker, James, 02044 VTT (FI); Guo, Bin, 02044 VTT (FI); Gao, Feng, 02044 VTT (FI)
(74) Representative: Seppo Laine Oy

(57) **Abstract**

The present invention concerns a hermetic silicon wafer structure comprising a patterned SOI MEMS wafer, a single crystal Si cap attached to the SOI MEMS wafer, and a hermetic silicon-oxide sealing ring in between the said MEMS wafer and the single crystal Si cap. The invention also concerns a silicon wafer structure comprising a silicon-on-insulator wafer embodying MEMS devices, and a single crystal silicon cap attached to the silicon-on-insulator wafer by means of a silicon-oxide sealing ring such that the single crystal silicon cap, the silicon-oxide sealing ring and the silicon-on-insulator wafer define a hermetic cavity around the MEMS devices. Further, the invention concerns methods of fabricating a wafer and a method of manufacturing a Viable Engineered Substrate comprising a patterned SOI MEMS wafer and a single crystal Si cap.

## Description

### TECHNICAL FIELD OF THE INVENTION:

The present invention relates to a hermetic silicon (Si) wafer structure.

The invention also relates to a silicon wafer structure.

Further, the invention relates to fabrication methods of a hermetic silicon wafer structure.

Furthermore, the present invention relates to a method of manufacturing a viable engineered substrate (VES) comprising patterned SOI (silicon-on-insulator) MEMS (microelectromechanical systems) wafer and a single crystal Si cap.

### BACKGROUND OF THE INVENTION:

US 7,531,424 teaches SOI-MEMS structures and devices, and the fabrication thereof. The disclosed structures, devices and methods support the wafer-level encapsulation and vacuum packaging of SOI-MEMS devices. The structures and devices described include an isolation trench that electrically isolates device components from the surrounding substrate. Interconnect lines are then fabricated across or over the trench to allow or provide electrical access connections from outside the encapsulated region to the device region.

US 2013/0164867 A1 discloses a method of forming an embedded wafer level optical package. The method includes attaching a sensor die, PCB bars and an LED on adhesive tape laminated on a carrier, attaching a dam between two light sensitive sensors of the sensor die, encapsulating the sensor die, the PCB bars, the LED, and the dam in an encapsulation layer, debonding the carrier, grinding a top surface of the encapsulation layer, forming vias through the encapsulation layer to the sensor die and the LED, filling the vias with conductive material, metalizing the top surface of the encapsulation layer, dielectric coating of the top surface of the encapsulation layer, dielectric coating of a bottom surface of the encapsulation layer, patterning the dielectric coating of the bottom surface of the encapsulation layer, and plating the patterned dielectric coating of the bottom surface of the encapsulation layer.

US 2013/0119489 A1 teaches a method and apparatus for wafer-level solder hermetic seal encapsulation of MEMS devices. A plurality of MEMS devices are formed on a substrate, a sacrificial layer is formed to cover each of the MEMS devices and a protective cap layer is formed on the sacrificial layer. A release hole is formed through the protective cap layer to the underlying sacrificial layer, and a releasing agent is introduced through the release hole to remove the sacrificial layer under the protective cap layer and expose a MEMS device. Optionally, the MEMS device can be released with the same releasing agent or, optionally, with a secondary releasing agent. The release hole is solder sealed, to form a hermetic seal of the MEMS device. Optionally, release holes are formed at a plurality of locations, each over a MEMS device and the releasing forms a plurality of hermetic sealed MEMS devices on the wafer substrate, which are singulated to form separate hermetically sealed MEMS devices.

US 2012/0276677 A1 describes a method and structure of wafer level encapsulation of integrated circuit with cavity. The invention is related to shielding integrated devices using CMOS fabrication techniques to form an encapsulation with cavity. The integrated circuits are completed first using standard IC processes. A wafer-level hermetic encapsulation is applied to form a cavity above the sensitive portion of the circuits using IC-foundry compatible processes. The encapsulation and cavity provide a hermetic inert environment that shields the sensitive circuits from EM interference, noise, moisture, gas, and corrosion from the outside environment.

US 2006/0108675 A1 discloses an apparatus and methods for enabling wafer-scale encapsulation of microelectromechanical (MEM) devices to protect the MEMs from the ambient and to provide either a controlled ambient or a reduced pressure. In particular, methods for wafer-scale encapsulation of MEM devices are provided, which enable encapsulation of MEM devices under desired ambient conditions that are not determined by the deposition conditions of a sealing process in which MEM release via holes are sealed or pinched-off, and which prevent sealing material from being inadvertently deposited on the MEM device during the sealing process.

US 2005/0227400 A1 describes a method of processing a wafer, and particularly a cap wafer configured for mating with a device wafer in the production of a die package. Masking layers are deposited on oxide layers present on opposite surfaces of the wafer, after which the masking layers are etched to expose regions of the underlying oxide layers. Thereafter, an oxide mask is formed on the exposed regions of the oxide layers, but is prevented from forming on other regions of the oxide layers masked by the masking layers. The masking layers are then removed and the underlying regions of the oxide layers and the wafer are etched to simultaneously produce through-holes and recesses in the wafer. The oxide mask is then removed to allow mating of the cap wafer with a device wafer.

US 2006/0223301 A1 teaches a method for forming deep via airgaps in a semiconductor substrate. Said deep via airgaps are used to create through wafer vias filled with conductive material for three dimensional wafer to wafer interconnect structures also referred to as vertically stacking of wafers or three dimensional semiconductor integrated circuit devices. The method is comprising the steps of patterning a hole in the substrate, partly fill said hole with a sacrificial material (e.g. poly-Si), forming spacers on the sidewalls of the unfilled part of the hole (e.g. TEOS) to narrow the opening, removing through said narrowed opening the remaining part of the sacrificial material (e.g. by isotropic etching) and finally sealing the opening of the airgap by depositing a conformal layer (TEOS) above the spacers. The method of forming a deep via airgap is used to create wafer to wafer vertical stacking. After completion of conventional FEOL and BEOL processing the backside of the wafer will be thinned such that the deep via airgap is opened and conductive material can be deposited within said (airgap) via opening and a through wafer or deep via filled with conductive material is created.

Article by James R Dekker et al: A process for SOI resonators with surface micromachined covers and reduced electrostatic gaps, J. Micromech. Microeng. 20 (2010) 045003, discloses fabrication of resonators on silicon-on-insulator (SOI) wafers with sub-micron gaps and wafer level encapsulation. Non-aligned, high-temperature fusion bonding of a cover wafer over unreleased structures etched into a SOI wafer is followed by cover wafer stripping to reveal etched resonators beneath an oxide membrane. The bonded oxide membrane serves as the basis of a surface micromachined membrane which incorporates silicon nitride and a porous polysilicon layer to facilitate release and supercritical drying.

### SUMMARY OF THE INVENTION:

An object of the present invention is to provide a hermetic silicon wafer structure. Another object is to provide a silicon wafer structure.

Further, an object is to provide methods of fabricating a wafer. Furthermore, an object is to provide a method of manufacturing a viable engineered substrate comprising a patterned SOI MEMS wafer and a single crystal Si cap.

These and other objects are achieved by the present invention, as hereinafter described and claimed. Thus the invention concerns a hermetic silicon wafer structure comprising a patterned SOI MEMS wafer, a single crystal Si cap attached to the SOI MEMS wafer, and a hermetic silicon-oxide sealing ring in between the said MEMS wafer and the single crystal Si cap.

Preferably, the patterned SOI MEMS wafer forms all-silicon MEMS devices, including resonators, gyroscopes or accelerometers, and pressure sensors formed together with the Si cap (or by the Si cap).

A connection to the MEMS devices is preferably done on the single crystal Si cap.

The invention also concerns a silicon wafer structure comprising a silicon-on-insulator wafer embodying MEMS devices, and a single crystal silicon cap attached to the silicon-on-insulator wafer by means of a silicon-oxide sealing ring such that the single crystal silicon cap, the silicon-oxide sealing ring and the silicon-on-insulator wafer define a hermetic cavity around the MEMS devices.

The MEMS devices preferably include at least one resonator, gyroscope, accelerometer or pressure sensor. The MEMS devices are preferably contacted through the single crystal silicon cap.

Further, the invention concerns a method of fabricating a wafer according to claim 1, wherein the MEMS structure is not released, i.e. the silicon oxide below the SOI layer is not etched, before the bonding of the cap wafer to the MEMS wafer. The invention also concerns a method in which the device is only partially released before bonding. The invention furthermore concerns a method of fabricating a wafer according to claim 1, wherein the wafer level packaging is done when the MEMS is released through release holes in the Si cap and the hermetic encapsulation is achieved by depositing a sealing material over the top of the release holes.

The invention furthermore concerns a method of manufacturing a VES comprising a patterned SOI MEMS wafer and a single crystal Si cap, the method comprising pre-release direct fusion bonding to achieve high bonding strength and thus robust and hermetic built-in SiO2 sealing rings, grinding and polishing the cap is to the desired thickness, and releasing the MEMS devices and sealing the cavity in order to achieve wafer level encapsulation.

Considerable advantages are obtained by means of the present invention. According to an aspect of the invention there is provided a versatile wafer level encapsulation structure and its fabrication method for SOI based MEMS. Direct wafer bonding before the release of MEMS devices ensures high bonding strength and thus robust and hermetic built-in sealing rings. Poly-Si without insulating liners is filled into through Si vias and lateral undercuts to form simple and strong feedthroughs. Metallic sealing over the high aspect-ratio release holes leaves no noticeable contamination in the sealed cavity. The advantages include a simple and robust structure with standard (IC compatible) clean room processes, as well as hermetic and vacuum packaging with low cost.

According to another aspect of the invention there is provided a Viable Engineered Substrate (VES) concept, which is highly beneficial for cost effective and timely MEMS prototyping and production. The new VES concept enables MEMS design and fabrication with built-in wafer level encapsulation, which aims to supply pre-capped MEMS substrate wafer. The VES consists of a patterned SOI MEMS wafer and its single crystal Si cap. Pre-release direct fusion bonding ensures high bonding strength and thus robust and hermetic built-in SiO2 sealing rings. The cap is ground and polished to the desired thickness. Wafer level encapsulation can then be achieved by releasing the MEMS devices and sealing the cavity. The TSV and sealing can be accomplished by any number of means by the customer. One example is Poly TSV with metal sealing, called "Direct bonding, poly-Via and metallic sealing based wafer level encapsulation".

Currently there is no pre-capped MEMS wafer (VES wafer) available in the market. The VES service will simplify both design and fabrication/packaging processes. Thus this service will give cost effective and timely prototyping and or production to customers, especially SMEs. Hermetic and vacuum packaging is an essential requirement for many MEMS components. Effective wafer level packaging (WLP) enables low cost and high throughput production.

### BRIEF DESCRIPTION OF THE DRAWINGS:

For a more complete understanding of particular embodiments of the present invention and their advantages, reference is now made to the following descriptions, taken in conjunction with the accompanying drawings. In the drawings:
**Fig. 1** illustrates a schematic view of a process for production of a wafer according to a first embodiment of the present invention,
**Fig. 2** illustrates a schematic view of a cross-section of a wafer level encapsulation structure according to a second embodiment of the present invention,
**Fig. 3** illustrates a schematic view of a Viable Engineered Substrate (VES) according to an embodiment of the present invention, and
**Figs 4a and 4b** illustrate a schematic view of the Viable Engineered Substrate concept,
**Fig. 5** illustrates a schematic view of an alternative process for production of a wafer,
**Fig. 6** illustrates a schematic view of another alternative process for production of a wafer,
**Fig. 7** illustrates a schematic view of a wafer with MEMS devices according to an embodiment,
**Fig. 8** illustrates a schematic view of a wafer with MEMS devices according to a further embodiment.

### DETAILED DESCRIPTION OF EMBODIMENTS OF THE INVENTION:

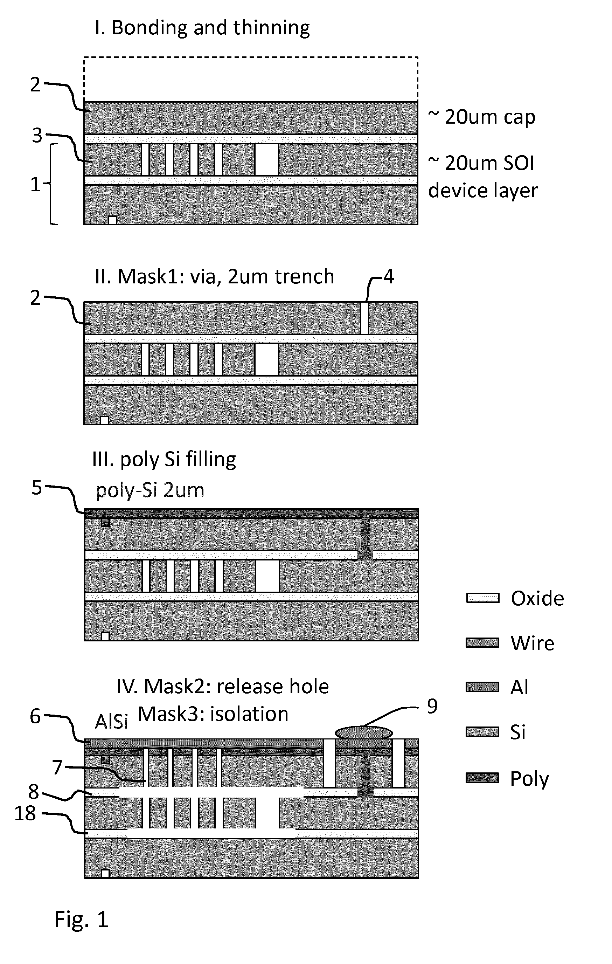

In **Fig. 1** a schematic view of a process for production of a wafer according to a first embodiment of the present invention is illustrated. The basic process for production of the proposed wafer level encapsulation component begins with an SOI wafer. Backside alignment mark patterning is followed by the front-side processing which culminates in the etching of the trench features on the wafer front-side, through the device layer to the buried oxide (BOX). The device wafer (sometimes referred to as the MEMS wafer or device wafer) is stripped and cleaned and bonded to a cap wafer using a fusion bonding process. Normally shunned, fusion bonding can be fast and reliable when using known design rules and processes. Furthermore, with low investment and consumable costs, it is also inexpensive. The components may be resonators, gyroscopes or accelerometers. However, in its simplest form this process is limited to silicon structures without metals.

The cap wafer is a simple, unpatterned conductive silicon wafer, oxidized and cleaned prior to bonding. After the bonding process, it is ground to the desired target thickness and polished with routine CMP. Typical target thickness for the cap wafer is in the range of 20 um. The processing of the cap starts with the TSV process to the buried device layer. Only 20um deep below the cap layer, the TSV may be formed by a simple polysilicon filled via, using around 2 um polysilicon. The process to fabricate this TSV is aided by the shallow depth and low aspect ratio.

Processing of the cap then consists of a release etch process and sealing with a metallic layer or with other thin films like poly-Si, oxide or nitride. An alternative to the poly-Si via is to form the TSV by electroplating followed by RDL, which is considerably more complex.

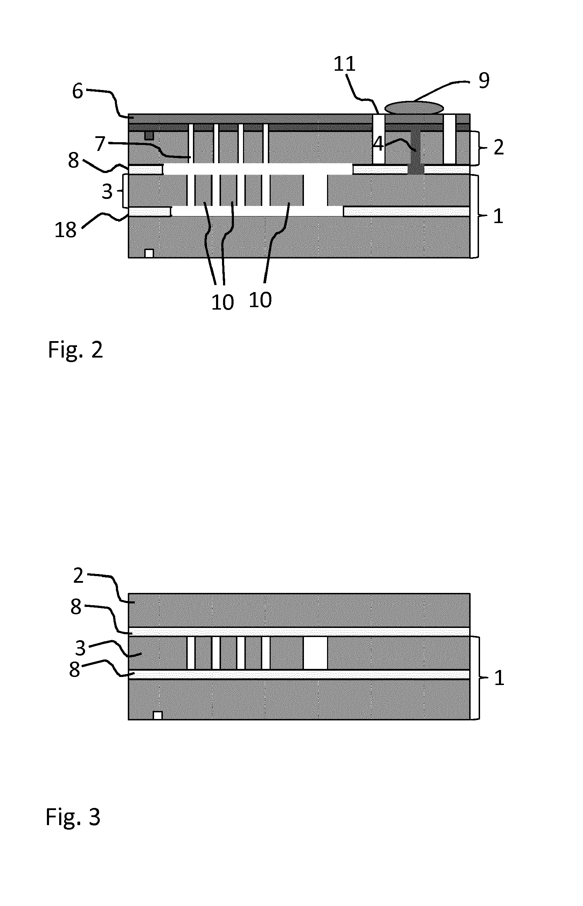

In **Fig. 2** a schematic view of a cross-section of a wafer according to a second embodiment of the present invention is illustrated. The TSV may be formed with another material such as Cu plating. The cavity may be sealed with another material such as PECVD poly-Si, oxide or nitride. Further, thicker layers may be added such as nitride or oxide polymer above the sealing metal.

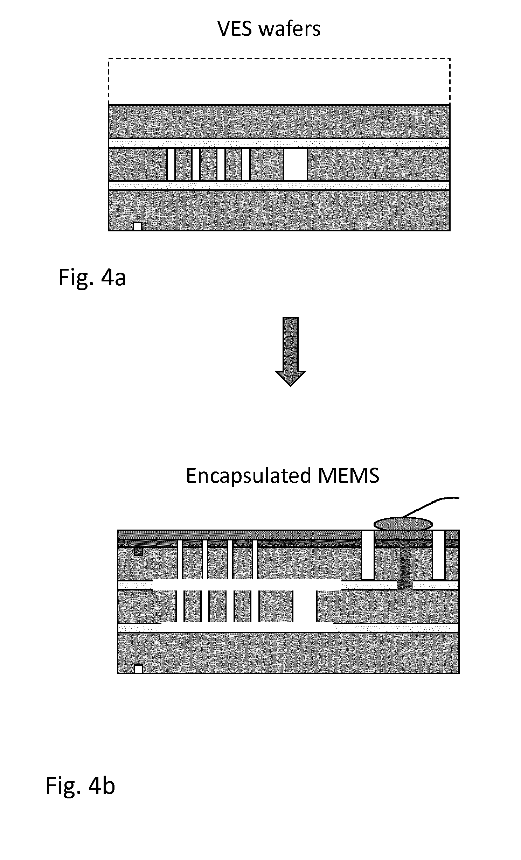

In **Fig. 3** a schematic view of a Viable Engineered Substrate (VES) according to an embodiment of the present invention is shown. The wafer level encapsulation structure of **Fig. 2** can be based on VES according to the embodiment of **Fig. 3****.** The new VES concept enables MEMS design and fabrication with built-in wafer level encapsulation, which aims to supply pre-capped MEMS substrate wafer. The VES consists of a patterned SOI MEMS wafer and its single crystal Si cap (Fig. 4a). Pre-release direct fusion bonding ensures high bonding strength and thus robust and hermetic built-in SiO2 sealing rings. The cap is ground and polished to the desired thickness. Wafer level encapsulation can then be achieved by releasing the MEMS devices and sealing the cavity (Fig. 4b). The TSV and sealing can be accomplished by any number of means by the customer. For example, before opening release holes, TSV-like feedthroughs can be formed by filling 2µm doped poly-Si into 2µm wide trenches.

The technology provides a versatile wafer level encapsulation structure and its fabrication method for SOI based MEMS. The advantages include a simple and robust structure with standard (IC compatible) clean room processes, as well as hermetic and vacuum packaging with low cost. The VES service simplifies both design and fabrication/packaging processes. Thus the development and prototyping of a product will be less expensive and in a shortened time to market.

Current major WLP solutions include epi-poly (thin film encapsulation), anodic bonding (between glass and Si wafer), and "Nasiri" process (metallic bonding). However, bonding often suffers from out-gassing, special process for the released delicate MEMS structures, in-compatibility of the sealing rings, and dedicated complex and expensive TSV capping wafers. Epi-poly process, on the other hand, is limited to narrow trenches. There can also be considerable contamination to the cavity by the sealing epi-poly.

Nowadays MEMS production involves many isolated stages which may be carried out in substrate houses, foundries and packages houses, respectively. Major IDMs produce their devices using own vertical integrated production lines, which however is highly device orientated and often limited to particular device types. It is well accepted that wafer level packaging will simplify MEMS production and lower down the cost. However, current WLP solutions have intrinsic limitations as mentioned above. In addition, current WLP is either done when the MEMS device is finished and released (e.g. bonding based WLPs), or done with certain devices and designs during the MEMS production (thin film encapsulation). There is no versatile WLP solution. Furthermore, there is no pre-capped MEMS substrate available in the market.

The VES is the first service in the market which can provide wafer level encapsulated MEMS substrate to the customers. In this way, the MEMS production is much simplified by combining substrate house, foundry and packaging house into the unique VES production service. Thus on one hand, the VES is obviously highly beneficial for the fabless or fablight companies, especially SMEs. On the other hand, IDMs can also migrate to the VES service to further lowering down their production cost and expanding their production line.

In **Figs 4a** and **4b** a schematic view of the Viable Engineered Substrate concept is shown. The figure illustrates the relationship between the VES and just one of the possible realizations of the final packaged MEMS wafer. In VES, there is no need for dedicated, preprocessed cap wafer. High yield fusion bonding leads to robust and cost effective packaging. The VES enables design for (wafer level) packaging and provides substrate with pre-capped MEMS devices, which simplifies the design to product cycle. The encapsulation based on VES can use poly-Si via connection which is simple and highly reliable. Direct metallic sealing can be used and is assisted by top narrowed high aspect ratio release holes, which gives rise to tightly sealed cavities and leaves no noticeable contamination to the cavity.

Normally fusion bonding requires very high surface smoothness and cleanliness, which is often difficult to achieve on etched surfaces especially when deep trenches are present. It will be much more difficult if the MEMS is released (where very limited cleaning process can be done on released structures). This is why conventionally only blanket bonding between Si and SiO2 wafers is done. This is also why people in the wafer level packaging field would rarely be willing to try this type of approach. However, it is possible to control the smoothness and cleanliness by process and design rules. The resulted fusion bonding is rather fast and reliable.

The new VES concept enables MEMS design and fabrication with built-in wafer level encapsulation, which aims to supply pre-capped MEMS substrate wafer. The VES consists of a patterned SOI MEMS wafer and its single crystal Si cap. Pre-release direct fusion bonding ensures high bonding strength and thus robust and hermetic built-in SiO2 sealing rings. The cap is ground and polished to the desired thickness. Wafer level encapsulation is then achieved by releasing the MEMS devices and sealing the cavity. Before opening release holes, TSV-like feedthroughs are formed by filling doped poly-Si into etched trenches in the Si cap. First, MEMS SOI wafer is patterned and bonded to the pre-oxidized cap wafer. As shown in our development, fusion bonding can be fast, reliable and with high yield. Release is then done directly through micro circular release holes etched into the poly-Si covered Si cap. A top narrowing DRIE process was developed to etch the 25µm deep release holes. The poly-Si layer used for the via connections further narrows the release hole top because of its lower etching rate in DRIE. After the MEMS structure was released by vapor HF, AlSi was deposited over the release holes. Narrowed release holes promote lateral growth and closing during AlSi deposition. There is no noticeable AlSi contamination at the bottom of the release holes. In the end, the packaging was finished by opening isolation trenches around the feedthrough pads.

According to an embodiment, the wafer level encapsulation structure is based on the VES substrate.

According to an embodiment, both Si Cap and the substrate can be thinned so that the form factor of the final packaged device can be very small (or competitive).

An embodiment of the present invention is a hermetic silicon wafer structure comprising a patterned SOI MEMS wafer, a single crystal Si cap attached to the SOI MEMS wafer, and a hermetic silicon-oxide sealing ring in between the said MEMS wafer and the single crystal Si cap.

An embodiment is a method of fabricating the wafer, wherein the MEMS structure is not released, i.e. the silicon oxide below the SOI layer is not etched.

An embodiment is a method of fabricating the wafer, wherein the Si cap is bonded to the MEMS wafer before the MEMS structure is released.

An embodiment is a method in which the etched MEMS device wafer is cleaned using, for example, industry standard liquid SC1 chemistry (NH4OH, H2O2, H2O in various ratios) or similar treatments, also including final water rinsing, before fusion bonding. Similar wet-cleaning chemistries are well-known throughout the industry to promote high bond strength.

An embodiment is a method of fabricating the wafer, wherein the wafer level packaging is done when the MEMS is released through release holes in the Si cap and the hermetic encapsulation is achieved by depositing a sealing material over the top of the release holes.

An embodiment is a method of manufacturing a VES comprising a patterned SOI MEMS wafer and a single crystal Si cap, the method comprising pre-release direct fusion bonding to achieve high bonding strength and thus robust and hermetic built-in SiO2 sealing rings, grinding and polishing the cap to the desired thickness, and releasing the MEMS devices and sealing the cavity in order to achieve wafer level encapsulation.

Other embodiments may have a device layer formed by CSOI (Cavity SOI) with buried oxide above the cavity. The cap may be formed by aligned bonding. At least one recess in the device layer may be formed for enlarged and controllable spacing between cap and the device layer. Plasma activated bonding may be used, e.g. for connections to CMOS. A CMOS circuit may be formed on the cap layer, i.e. CMOS last process.

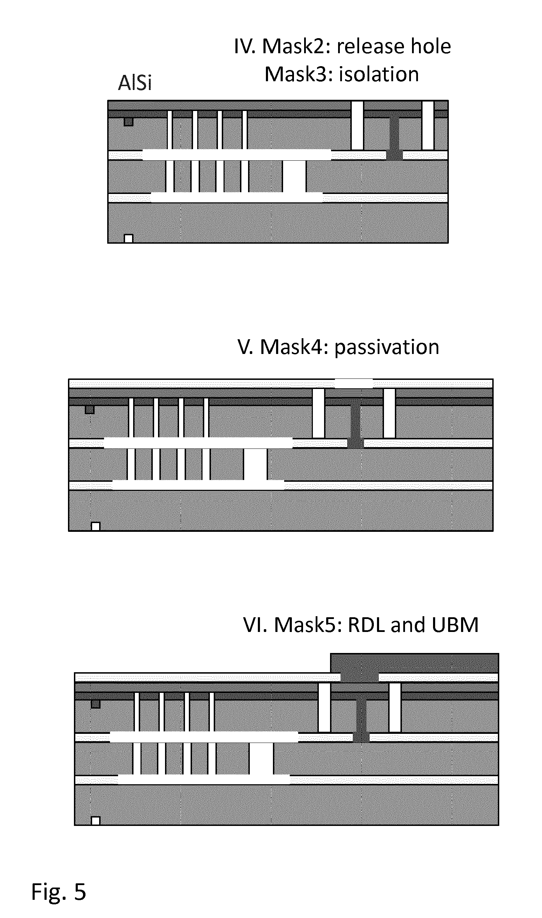

**Fig. 5** discloses an alternative embodiment wherein the process can be started as shown in steps I-III in **Fig. 1** but continued differently starting from step IV. The method comprises growing a passivation layer, such as a layer of silicon oxide, on the surface of AlSi layer, as shown in step V. After this, a redistribution layer (RDL) and under bump metallization (UBM) can manufactured in step VI. The UBM and RDL can be made, for example, by preparing a mask by means of photolithography and growing a layer of NiAu in the openings in a patterned mask. The growing can also be made first and the layer patterned afterwards by means of photolithography and a suitable etch as is known in the art. After this, a bump can be made on top of the UBM. Of course, it is also possible to omit the RDL part of the NiAu layer, or a corresponding layer of other suitable material, such as other metal, if the bump is co-located with the via.

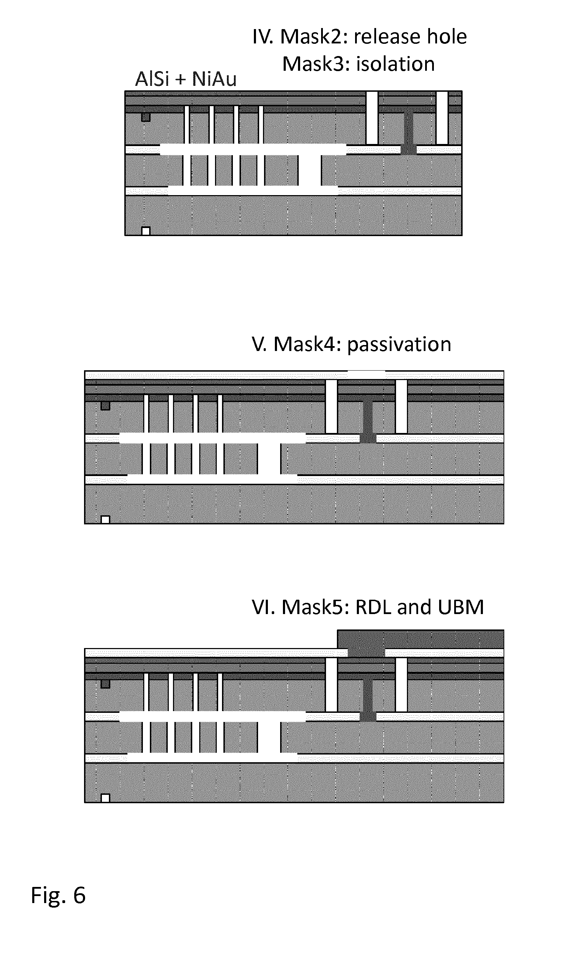

**Fig. 6** discloses another alternative embodiment wherein the process is substantially similar to that of **Fig. 5**, except that a layer of NiAu, or other suitable metal, is grown on top of the AlSi layer, or a corresponding layer of other material, in step IV.

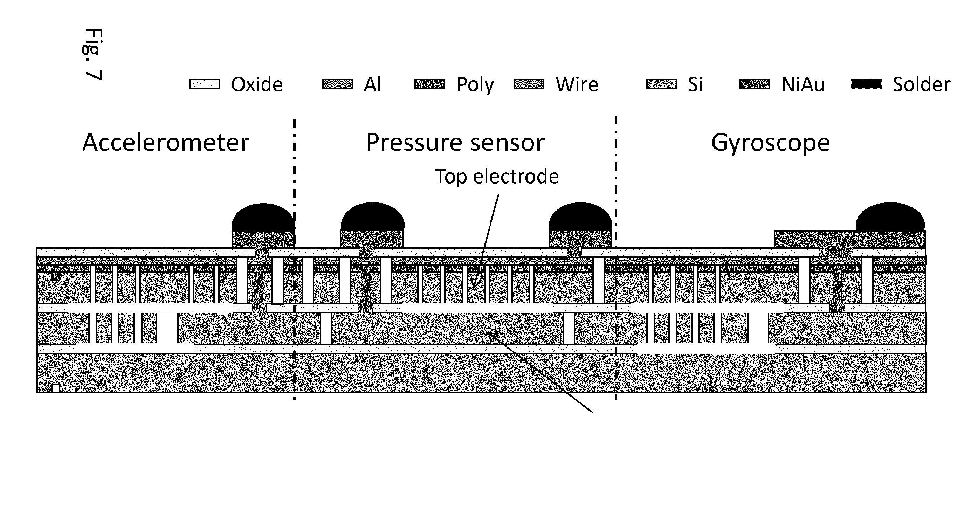

The process of **Fig. 5** can be used to manufacture wafers in which different devices are processed using the same process flow and sealed under the same pressure. An example of such structures is shown in **Fig. 7****.** Thus, for example an accelerometer, pressure sensor and/or a gyroscope, or any combination of two of them, can be made in the same process inside the same wafer structure.

According to an embodiment of such a structure comprising two or more devices, all the devices are sealed under low pressure (vacuum).

According to an embodiment of such a structure comprising an accelerometer and one or more other devices, electrical (active) damping is provided for the accelerometer to prevent unwanted oscillation.

The pressure sensor illustrated in **Fig. 7** is a capacitive sensor, while piezoresistive sensor can also be implemented by depositing a piezoresitive material on top of the Si cap, or by doping the Si cap to form piezoresistive sensors. The piezoresitive function can replace the capacitive function or the device can have both a capacitive and piezoresitive functionality.

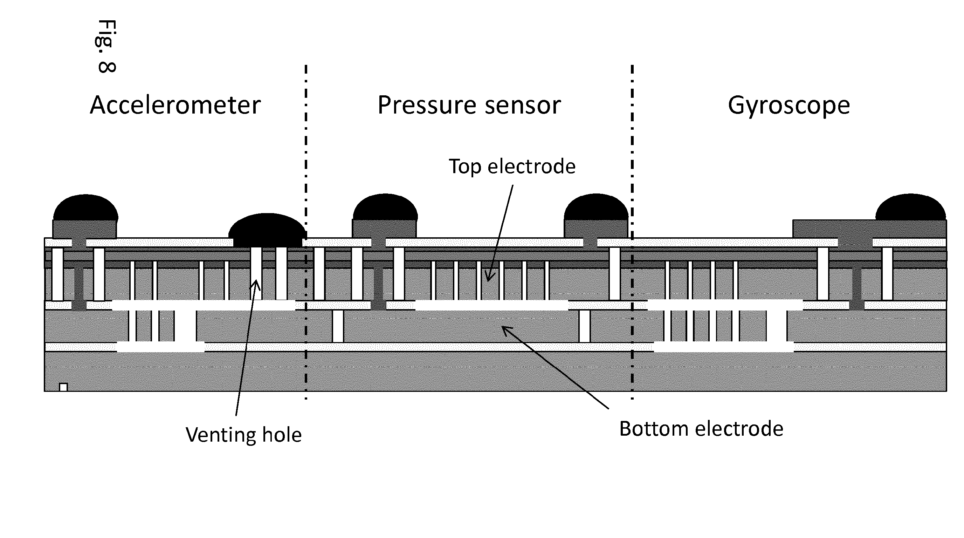

The process of **Fig. 6** can be used to manufacture wafers in which different devices are processed using the same process but are vented and sealed under at least one pressure, which can be a high pressure and do not necessarily need to be the same for all of the components. An example of such structures is shown in **Fig. 8****.**

According to an embodiment relating to the process of **Fig. 6**, after sealing (deposition of the AlSi and NiAu over the released cavity), the accelerometer in the combo chip is vented. Then, the accelerometer is resealed by placing a solder ball on top of the venting hole and reflow the solder ball under relatively high ambient pressure (e.g. 0.5-1bar in N2). After this, a similar venting/reflow process can be used for any devices to achieve controlled pressure and ambient gas inside the sealed cavity. Thus, each device can be sealed in an individual pressure such that there are for example two or three different pressures inside the structure.

According to an embodiment, there is provided a hermetic silicon wafer structure comprising a patterned SOI MEMS wafer 1, a single crystal Si cap 2 attached to the SOI MEMS wafer 1, and a hermetic silicon-oxide sealing ring 8 in between the said MEMS wafer 1 and the single crystal Si cap 2.

According to an embodiment, the patterned SOI MEMS wafer 1 forms all-silicon MEMS devices 10, such as resonators, gyroscopes, accelerometers and/or pressure sensors.

According to an embodiment, the patterned SOI MEMS wafer 1 forms said all-silicon MEMS devices 10 together with the Si cap 2 such that the Si cap 2 is used as a sensing membrane and/or a top electrode.

According to an embodiment, an electrical connection to the MEMS devices 10 is done through the single crystal Si cap 2.

According to an embodiment, the electrical connection is formed by a via 4 that has been filled with a polysilicon filling 5 or other suitable material. A wire 9 can be connected to via 4 to conduct electrical signals between the SOI device layer 3 and external circuitry. Then, the SOI device layer 3 acts as a first electrode and a portion of the Si cap layer 2 can act as a second electrode, which can also be connected to the external circuitry. The via 4 is electrically separated from the second electrode portion of the Si cap layer 2 by means of a trench 11 (see **Fig. 2**).

According to an embodiment, the insulator layer 18 of SOI wafer 1 is made of silicon-oxide having a first etch rate and the hermetic silicon-oxide sealing ring 8 is made of silicon-oxide having a second etch rate such that the second etch rate is 50-200 % of the first etch rate, such as 75-125 % or preferably 85-115 % of the first rate. Thus, the first and second etch rates are equal or at least substantially equal.

According to an embodiment, the thickness of the single crystal Si cap 2 is between 10-50 micrometers, such as 15-35 or 20-25 micrometers. This thichness is to keep the cap 2 thick enough to resist atmospheric pressure and still thin enough to allow easy manufacturing of the vias 4.

According to another embodiment, there is provided a silicon wafer structure comprising a silicon-on-insulator wafer 1 embodying MEMS devices 10, and a single crystal silicon cap 2 attached to the silicon-on-insulator wafer 1 by means of a silicon-oxide sealing ring 8 such that the single crystal silicon cap 2, the silicon-oxide sealing ring 8 and the silicon-on-insulator wafer 1 define a hermetic cavity around the MEMS devices 10.

According to an embodiment, the insulator layer 18 of the silicon-on-insulator wafer 1 and a silicon-oxide layer forming the silicon-oxide sealing ring 8 are in contact with the MEMS devices 10 such that the MEMS devices 10 are in an inoperable storage state from which they can be released to an operable state by etching away the portions of the insulator layer and the silicon-oxide layer in contact with the MEMS devices 10.

According to an embodiment, the MEMS devices 10 include at least one resonator, gyroscope, accelerometer and/or pressure sensor.

According to an embodiment, the MEMS devices 10 are contacted through the single crystal silicon cap 2.

According to an embodiment, there is provided a method of manufacturing a silicon device structure, the method comprising
patterning a silicon layer 3 on an insulator layer 18 of a silicon-on-insulator wafer 1 for producing silicon structures for MEMS devices 10, and
bonding a single crystal silicon cap 2 onto the silicon layer 3 by means of a silicon-oxide sealing layer 8.

According to an embodiment, the method comprises releasing the silicon structures of the MEMS devices 10 by etching the insulator layer (oxide layer 18) after said step of bonding, whereby the silicon structures (those that form devices 10) are supported by the insulator layer (oxide layer 18) during bonding.

According to an embodiment, the releasing step comprises etching away a portion of the silicon-oxide sealing layer (layer that forms the oxide sealing ring 8).

According to an embodiment, the method comprises etching the insulator layer (oxide layer 18) at a first etch rate and the silicon-oxide sealing layer 8 at a second etch rate such that the second etch rate is 50-200 % of the first etch rate, such as 75-125 % or 85-115 % of the first rate.

According to an embodiment, the etching is performed through release holes 7 in the single crystal silicon cap 2 and the method comprises depositing a sealing material, such as AlSi 6, over the top of the release holes 7 after said etching in order to hermetically encapsulate the MEMS devices. The etching can be made by means of HF vapour, for instance.

According to an embodiment, the bonding is made by direct fusion bonding.

According to an embodiment, the method comprises grinding and polishing the bonded single crystal silicon cap 2 to a thickness of 10-50 micrometers, such as 15-35 or 20-25 micrometers.

Although the present invention has been described in detail for the purpose of illustration, various changes and modifications can be made within the scope of the claims. In addition, it is to be understood that the present disclosure contemplates that, to the extent possible, one or more features of any embodiment may be combined with one or more features of any other embodiment.

### List of reference numbers:

- 1: wafer
- 2: Si cap layer
- 3: SOI device layer
- 4: via
- 5: poly-Si filling
- 6: AlSi layer
- 7: release hole
- 8: oxide sealing ring
- 9: wire
- 10: MEMS devices
- 11: trench
- 18: oxide layer of SOI wafer

## Claims

1. A hermetic silicon wafer structure comprising
- a patterned SOI MEMS wafer,
- a single crystal Si cap attached to the SOI MEMS wafer, and
- a hermetic silicon-oxide sealing ring in between the said MEMS wafer and the single crystal Si cap.

2. The hermetic silicon wafer structure according to claim 1, wherein the patterned SOI MEMS wafer forms all-silicon MEMS devices, such as resonators, gyroscopes, accelerometers and/or pressure sensors.

3. The hermetic silicon wafer structure according to claim 2, wherein the patterned SOI MEMS wafer forms said all-silicon MEMS devices together with the Si cap.

4. The hermetic silicon wafer structure according to claim 2, wherein an electrical connection to the MEMS devices is done through the single crystal Si cap.

5. The hermetic silicon wafer structure according to claim 4, wherein the electrical connection is formed by a via made of polysilicon.

6. The hermetic silicon wafer structure according to any one of claims 1-5, wherein the insulator layer of SOI wafer is made of silicon-oxide having a first etch rate and the hermetic silicon-oxide sealing ring is made of silicon-oxide having a second etch rate such that the second etch rate is 50-200 % of the first etch rate, such as 75-125 % or preferably 85-115 % of the first rate.

7. The hermetic silicon wafer structure according to any one of claims 1-6, wherein the thickness of the single crystal Si cap is between 10-50 micrometers, such as 15-35 or 20-25 micrometers.

8. A silicon wafer structure comprising
- a silicon-on-insulator wafer embodying MEMS devices, and
- a single crystal silicon cap attached to the silicon-on-insulator wafer by means of a silicon-oxide sealing ring such that the single crystal silicon cap, the silicon-oxide sealing ring and the silicon-on-insulator wafer define a hermetic cavity around the MEMS devices.

9. The silicon wafer structure according to claim 8, wherein the insulator layer of the silicon-on-insulator wafer and a silicon-oxide layer forming the silicon-oxide sealing ring are in contact with the MEMS devices such that the MEMS devices are in an inoperable storage state from which they can be released to an operable state by etching away the portions of the insulator layer and the silicon-oxide layer in contact with the MEMS devices.

10. The silicon wafer structure according to claim 8 or 9, wherein the MEMS devices include at least one resonator, gyroscope, accelerometer and/or pressure sensor.

11. The silicon wafer structure according to any one of claims 8-10, wherein the MEMS devices are contacted through the single crystal silicon cap.

12. A method of manufacturing a silicon device structure, the method comprising
- patterning a silicon layer on an insulator layer of a silicon-on-insulator wafer for producing silicon structures for MEMS devices, and
- bonding a single crystal silicon cap onto the silicon layer by means of a silicon-oxide sealing layer.

13. The method of claim 12, comprising releasing the silicon structures of the MEMS devices by etching the insulator layer after said step of bonding, whereby the silicon structures are supported by the insulator layer during bonding.

14. The method of claim 13, wherein the releasing step comprises etching away a portion of the silicon-oxide sealing layer.

15. The method of claim 14, comprising etching the insulator layer at a first etch rate and the silicon-oxide sealing layer at a second etch rate such that the second etch rate is 50-200 % of the first etch rate, such as 75-125 % or 85-115 % of the first rate.

16. The method according to any one of claims 13-15, wherein the etching is performed through release holes in the single crystal silicon cap and the method comprises depositing a sealing material over the top of the release holes after said etching in order to hermetically encapsulate the MEMS devices.

17. The method according to any one of claims 12-16, wherein the bonding is made by direct fusion bonding.

18. The method according to any one of claims 12-17, comprising grinding and polishing the bonded single crystal silicon cap to a thickness of 10-50 micrometers, such as 15-35 or 20-25 micrometers.
